(19) Europäisches Patentamt / European Patent Office / Office européen des brevets

(11) EP 4 692 414 A1

(12) **EUROPEAN PATENT APPLICATION**
published in accordance with Art. 153(4) EPC

(43) Date of publication:
**11.02.2026 Bulletin 2026/07**

(21) Application number: **24784932.6**

(22) Date of filing: **03.04.2024**

(51) International Patent Classification (IPC):
***C23C 16/40*** (2006.01) ***C01B 32/25*** (2017.01)
***C08K 3/013*** (2018.01) ***C08L 101/00*** (2006.01)
***C23C 16/44*** (2006.01) ***H01L 23/373*** (2006.01)

(52) Cooperative Patent Classification (CPC):
**C23C 16/4417; C01B 32/25; C08K 3/013; C08L 101/00; C23C 16/403; C23C 16/45525; H01L 23/373**

(86) International application number:
**PCT/JP2024/013729**

(87) International publication number:
**WO 2024/210148 (10.10.2024 Gazette 2024/41)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.04.2023 US 202363457193 P**

(71) Applicants:
- **Sekisui Chemical Co., Ltd.**
  **Osaka-shi, Osaka 530-8565 (JP)**
- **Forge Nano Inc.**
  **Thornton, CO 80241 (US)**

(72) Inventors:
- **SHIBUTA, Kaoru**
  **Mishima-gun, Osaka 618-0021 (JP)**
- **SCARIA, Abison**
  **Mishima-gun, Osaka 618-0021 (JP)**
- **ISHIDA, Hiroya**
  **Mishima-gun, Osaka 618-0021 (JP)**
- **GRONER, Markus**
  **Thornton, Colorado 80241 (US)**

(74) Representative: **Ter Meer Steinmeister & Partner Patentanwälte mbB**
**Nymphenburger Straße 4**
**80335 München (DE)**

# (54) DIAMOND COMPOSITE PARTICLE AND RESIN COMPOSITION

(57) A diamond composite particle having a diamond particle and a coating film that coats a surface of the diamond particle, in which the coating film contains a metal oxide, the coating film has an average coating thickness of 0.5 nm or more and 3 nm or less, and a ratio of a standard deviation of a coating thickness to the average coating thickness (standard deviation/average thickness) is 0.6 or less.

EP 4 692 414 A1

## Description

### Technical Field

The present invention relates to a diamond composite particle and a resin composition containing the diamond composite particle.

### Background Art

As electronic circuits are getting more highly integrated, thermal interface materials (TIMs) are becoming more important. TIM is a material obtained by loading a thermally conductive filler into a matrix resin, and a filler having a higher thermal conductivity is desirably used to improve the heat radiation properties of TIM. Among fillers having a high thermal conductivity, diamond particles are excellent in terms of thermal conductivity, insulating properties, wear resistance and the like, and diamond particles have been thus conventionally used.

Conventionally, there have been studies regarding a variety of surface treatments that are performed on fillers such as diamond particles. For example, Patent Literature 1 discloses an adhesive composition containing a carbon-based particle having an electrically insulating coating with ceramic (metal oxide), and diamond is exemplified as an example of the carbon-based particle in the literature. Patent Literature 1 describes a range of 10 nm to 100 μm as the thickness of the electrically insulating coating at the time of coating the diamond surface and describes a gist of not allowing the thermal conductivity to decrease to a desired value or less due to a change in the thickness. In addition, Patent Literature 1 specifically discloses coating by CVD.

In addition, as a method for forming a nano-level thin film on an inorganic particle of a filler or the like, for example, an ALD method (atomic layer controlled growth method) is known. For example, Patent Literature 2 discloses a non-agglomerated particle composed of a nitride particle or a metal particle having an inorganic thin film of silica or alumina on the surface and a resin matrix loaded with the non-agglomerated particle. Patent Literature 2 describes that the inorganic thin film is formed by the ALD method (atomic layer controlled growth method) and the thickness of the inorganic thin film is 0.5 to 35 nm.

### Citation List

#### Patent Literature

PTL 1: Japanese Translation of PCT International Application Publication No. 2013-506029
PTL 2: Japanese Translation of PCT International Application Publication No. 2005-501176

### Summary of the Invention

#### Technical Problem

Incidentally, according to the present inventors' studies, it was found that the use of a diamond particle as a heat radiation material of TIM leads to poor heat resistance. In order to prevent this, the present inventors performed a coating treatment of a diamond particle by the CVD method, which is disclosed in Patent Literature 1 or the like, a sol-gel method or the like, but found that the coating treatment makes the thickness of a coating film hard to control and thick and there is thus a problem in that the thermal conductivity of the TIM decreases. On the other hand, in a case where TIM has been fabricated using a diamond particle having a coating film formed by an ordinary ALD method as disclosed in Patent Literature 2, the heat resistance of the TIM deteriorates in some cases.

Therefore, an object of the present invention is to provide a diamond composite particle capable of satisfying both excellent thermal conductivity and heat resistance when composited with a resin.

#### Solution to Problem

As a result of intensive studies, the present inventors performed a study regarding a cause of poor heat resistance in the conventional ALD method and found that the continuity or uniformity of a coating film is disrupted due to the heterogeneity and low reactivity of a functional group that is present on the diamond surface. In addition, it was found that the elution of a metal impurity that is present on the surface of the diamond particle into a composition from an uncoated place due to the disrupted continuity or uniformity of the coating film affects the heat resistance when the diamond particle

is composited with a resin. Based on such findings, it was found that the above-described object can be achieved by controlling the coating thickness of a metal oxide that coats the surface of a diamond particle and a variation in the coating thickness within certain ranges.

That is, the present invention provides the following [1] to [7].

[1] A diamond composite particle comprising: a diamond particle; and a coating film that coats a surface of the diamond particle, the coating film comprising a metal oxide, the coating film having an average coating thickness of 0.5 nm or more and 3 nm or less, and a ratio of a standard deviation of a coating thickness to the average coating thickness (standard deviation/average coating thickness) being 0.6 or less.
[2] The diamond composite particle according to [1], wherein the metal oxide is aluminum oxide.
[3] The diamond composite particle according to [1] or [2], wherein the diamond composite particle has an average particle diameter of 1 μm or more and 80 μm or less.
[4] A resin composition comprising: a base resin; and the diamond composite particles according to any one of [1] to [3].
[5] The resin composition according to [4], wherein the base resin comprises at least one selected from the group consisting of a silicone resin, an epoxy resin, a polyolefin resin and an acrylic resin.
[6] The resin composition according to [4] or [5], further comprising a dispersant, wherein the dispersant has a different structure from the base resin.
[7] The resin composition according to any one of [4] to [6], wherein a content of the diamond composite particles in the resin composition is 10% by mass or more and 99% by mass or less based on 100% by mass of the resin composition.

Advantageous Effect of Invention

According to the present invention, it is possible to provide a diamond composite particle capable of satisfying both excellent thermal conductivity and heat resistance when composited with a resin.

Brief Description of Drawing

[Fig. 1] Fig. 1 is a view simply showing a cycle of an ALD method.

Description of Embodiments

[Diamond composite particle]

A diamond composite particle of the present invention has a diamond particle that configures the core of the diamond composite particle and a coating film that coats the surface of the diamond particle. In the diamond composite particle of the present invention, the coating film contains a metal oxide and has an average coating thickness of 0.5 nm or more and 3 nm or less, and the ratio of the standard deviation of the coating thickness to the average coating thickness (hereinafter, also referred to as "standard deviation/average thickness") is 0.6 or less.

In a case where the average coating thickness exceeds 3 nm, the coating film becomes thick, and there is a concern that it may not be possible to impart excellent thermal conductivity to a resin composition due to the diamond particle. In addition, in a case where the average coating thickness is below 0.5 nm, it is not possible to sufficiently coat the surface of the diamond particle, whereby there is a concern that it may not be possible to sufficiently impart excellent heat resistance to a resin composition when the diamond composite particle is composited with a resin. From these viewpoints, the average coating thickness is preferably 0.5 nm or more and 2 nm or less and more preferably 0.7 nm or more and 1.5 nm or less.

In addition, there are cases where a metal impurity is attached to the surface of the diamond particle in a synthesis process thereof, but in a case where the standard deviation/average thickness exceeds 0.6, a variation in the coating thickness of the diamond composite particle becomes large, the metal impurity on the surface of the diamond particle is likely to be eluted into a resin composition, and there is a concern that it may not be possible to impart excellent heat resistance to the resin composition. From the above-described viewpoint, the standard deviation/average thickness is preferably 0.5 or less and more preferably 0.4 or less.

From the viewpoint of decreasing the variation in the coating thickness of the diamond composite particle and imparting excellent heat resistance to a resin composition, the standard deviation/average thickness is preferably as small as possible, and it may be 0 or more. When a possibility of the metal impurity being attached to the surface of the diamond particle in the synthesis process of the diamond particle is taken into account, the standard deviation/average thickness is, for example, 0.01 or more and preferably 0.03 or more from the practical viewpoint.

Examples of the metal oxide that is contained in the coating film that configures the diamond composite particle of the present invention include a variety of metal oxides. The meaning of "metal" in the metal oxides includes semi-metal such as silicon as well. Specific examples of the metal oxides include silicon oxide (silica), aluminum oxides such as alumina and boehmite, titanium oxide, zinc oxide and the like. Among these, aluminum oxides are preferable, and alumina is more preferable from the viewpoint of making it easy to form a thin and uniform coating film.

The coating film is preferably a coating film that is formed of the metal oxide. Typically, the coating film may contain a compound selected from the group consisting of the metal oxides as a main component. In order to be contained as a main component, the content of the metal oxide may be, for example, 50% by mass or more, preferably 70% by mass or more, more preferably 90% by mass or more and 100% by mass or less and still more preferably 99% by mass or more and 100% by mass or less of the entire coating film.

In the present invention, the coating film is preferably formed on the surface of the diamond particle by an atomic layer controlled growth method (ALD method). When the coating film is formed by the ALD method, the coating film is thinly formed, and it becomes easy to curb the average coating thickness to a predetermined numerical value or less. In addition, the uniformity of the coating film increases, and it also becomes easy to curb the standard deviation/average thickness to a predetermined numerical value or less.

In the case of forming the coating film by the ALD method, the following steps (1) to (5) are performed on the diamond particle as one cycle, and the coating film is preferably formed by performing the steps a plurality of cycles. Hereinafter, the steps will be described with reference to Figure 1, and an example where trimethylaluminum (TMA) is used as a metal-containing gas and water vapor is used as an oxidizing agent will be shown in Figure 1, but the steps are not limited thereto.

(1) A metal-containing gas is supplied as a precursor into a reaction chamber of an ALD device (hereinafter, also simply referred to as "reaction chamber") to load the metal-containing gas into the reaction chamber.
(2) The metal-containing gas is reacted with the diamond particle surface in the reaction chamber to bond the metal-containing gas to the diamond particle surface.
(3) A by-product generated by the above reaction and the metal-containing gas that did not react with the hydroxyl group are purged, and an oxidizing agent is then supplied as a new precursor to load the oxidizing agent into the reaction chamber.
(4) The metal-containing gas attached to the diamond particle surface is oxidized in the reaction chamber with the oxidizing agent.
(5) A by-product generated by the above oxidation and the oxidizing agent that was not used for the oxidation are purged.

The ALD device is not particularly limited as long as the device is capable of synthesizing the diamond composite particle of the present invention, but a fluidized-bed reaction device is preferably used. In the fluidized-bed reaction device, it is possible to stir the diamond particle by vibration or the like while forming a fluidized bed in a reactor. Therefore, the use of the fluidized-bed reaction device makes it easy to form a thin and uniform coating film on the surface of the diamond particle.

The metal-containing gas that is supplied in the step (1) may be a gas that is capable of forming a metal oxide by reacting with a hydroxyl group of the diamond particle or a hydroxyl group of a metal oxide that coats the diamond particle and being then oxidized with an oxidizing agent such as water vapor.

The metal-containing gas may be a gas containing a silicon element, an aluminum element, a titanium element or a zinc element, and examples thereof include alkyl metals composed of a metal element and an alkyl group such as a methyl group or an ethyl group. Examples of the alkyl metals include methyl metals such as trimethylaluminum (TMA), trimethyltitanium (TMTi), trimethylsilane (TMS) and dimethylzinc ($(CH_3)_2Zn$), and among these, trimethylaluminum is preferable. In the step (1) or the step (3) to be described below, the metal-containing gas or the oxidizing agent may be supplied to the reactor together with an inert gas such as a nitrogen gas as a carrier gas.

In the step (2), the metal-containing gas may be reacted with a hydroxyl group that is present on the surface of the diamond particle (Figure 1(a)). In addition, the steps (1) to (5) are repeatedly performed a plurality of cycles as described above; however, in a case where the metal oxide has already bonded to the diamond particle surface in the previous cycle, the metal-containing gas may be further bonded to the metal oxide that has already bonded to the diamond particle surface in the step (2) (Figure 1(c)). The steps (1) to (5) are repeated a certain number or more of cycles as described above, whereby the metal-containing gas bonds to the metal oxide repeatedly, and a coating film having a certain film thickness is thereby formed.

In a case where an alkyl metal is used as the metal-containing gas, the by-products that are generated in the steps (2) and (4) are alkane gases, and in a case where a methyl metal such as trimethylaluminum is used, the by-products are methane gases.

Purging in the steps (3) and (5) may be performed under a reduced-pressure condition and is preferably performed at a degree of vacuum of, for example, 0.2 torr or higher and 100 torr or lower.

Examples of the oxidizing agent that is used in the step (3) include $H_2O$ (water vapor gas). It is preferable that the use of $H_2O$ (water vapor gas) makes the metal-containing gas that has bonded to the diamond particle surface or further bonded to the metal oxide bonding to the diamond particle surface be hydrolyzed in the step (4) (Figures 1(b) and 1(d)).

In the present production method, an approximately 0.1 nm coating film can be formed by the above-described one cycle. Therefore, in order to obtain the diamond composite particle of the present invention, the number of cycles repeated is preferably three times or more and 50 times or less, more preferably five times or more and 30 times or less and still more preferably within a range of six times or more and 15 times or less.

In addition, the steps (1) and (2) may be performed only once or twice per cycle. That is, in the one cycle, (1), (2), (3), (4) and (5) may be continuously performed in this order or (1), (2), (1), (2), (3), (4) and (5) may be continuously performed in this order.

In addition, in the case of performing the steps (1) and (2) twice in one cycle, it is also preferable that the steps (1) and (2) are performed twice in the first cycle and the steps (1) and (2) are performed once per cycle in the second and following cycles. A method in which the steps (1) and (2) are performed twice in the first cycle and the steps (1) and (2) are performed only once per cycle in the second and following cycles as described above is also referred to as "initial continuous supply method." The use of the initial continuous supply method makes it easy for the hydroxyl group on the diamond particle and the metal-containing gas to react with each other and makes it easy to uniformly form the coating film.

In addition, the temperature in the reaction chamber in the reaction in the step (2) is preferably 170°C or higher, more preferably 200°C or higher and still more preferably 230°C or higher. Ordinarily, the hydroxyl group that is present on the surface of the diamond particle has a low reactivity; however, in the present invention, the reaction temperature is set to a predetermined temperature or higher, whereby the reactivity between the metal-containing gas, such as TMA, and the hydroxyl group is enhanced, and it becomes easy to uniformly form the coating film.

In the oxidation reaction in the step (4) as well, the temperature in the reaction chamber is preferably 170°C or higher, more preferably 200°C or higher and still more preferably 230°C or higher. When the reaction temperature in the step (4) is set to a predetermined temperature or higher, it becomes easy to advance the oxidation reaction, and it becomes easy to uniformly form the coating film.

In what has been described above, in each cycle, the temperature in at least any of the reaction in the step (2) and the oxidation in the step (4) is preferably set to 170°C or higher, but the temperatures in both the reaction and the oxidation are more preferably set to 170°C or higher, still more preferably set to 200°C or higher and particularly preferably set to 230°C or higher. In addition, it is still more preferable to use the initial continuous supply method and set the temperatures in both the reaction in the step (2) and the oxidation in the step (4) to 170°C or higher. When the coating film is formed by such a method, it becomes easy to more uniformly form the coating film.

The temperatures in the reaction chamber in the reaction in the step (2) and the reaction in the step (4) are not particularly limited, but may be, for example, 800°C or lower and are preferably 500°C or lower. In addition, the temperatures in the reaction chamber in the reaction in the step (2) and the reaction in the step (4) may be the same as or different from each other in the reaction in the step (2) and the reaction in the step (4), but are preferably the same.

In order to confirm the completion of the reaction and the oxidation in the steps (3) and (5) and move to the next procedure, it is preferable to confirm the completion by performing reaction tracking by, for example, the mass spectrometry. Specifically, in a case where the reaction in the step (2) has been completed, since the surplus of the metal-containing gas that was not used in the reaction is detected as a peak, when it is possible to confirm the peak, it is preferable that the metal-containing gas or the by-product of the reaction in the step (2) is purged and, furthermore, the oxidizing agent is then supplied as a new precursor. In addition, in a case where the oxidation reaction in the step (4) has been completed, since no generation peaks of the by-product (for example, methane) are detected, when it is possible to confirm that no generation peaks are detected, it is preferable to purge the oxidizing agent or the by-product of the oxidation reaction in the step (4).

In the present invention, the diamond particle may be dried in advance before the cycle of the steps (1) to (5) is performed. Conditions for drying the diamond particle in advance are not particularly limited, but the diamond particle is preferably dried under conditions of, for example, 200°C to 300°C and approximately one to 10 hours.

The diamond particle may be an as-grown particle or a crushed diamond particle obtained by crushing an as-grown particle or may be a diamond particle other than the above-described particles, and two or more thereof may be jointly used. Ordinarily, the as-grown particle is a crystalline diamond particle that is not crushed or the like and maintains the shape formed during synthesis and has a polyhedral shape of an octahedron, a truncated octahedron or the like. The crushed diamond particle is a particle obtained by crushing the crystalline diamond particle and ordinarily has an angular shape due to crushing.

As the diamond particle, a crushed diamond particle is preferably used. In the case of using a crushed diamond particle, the entire core that configures the diamond composite particle may be the crushed diamond particle, but the crushed diamond particle and a particle other than the crushed diamond particle, such as the as-grown particle, may also

be jointly used. In the diamond composite particle, the proportion of the crushed diamond particle may be, for example, 5% by volume or more and 100% by volume or less and is preferably 10% by volume or more and 100% by volume or less, more preferably 50% by volume or more and 100% by volume or less, still more preferably 70% by volume or more and 100% by volume or less and far still more preferably 90% by volume or more and 100% by volume or less. The proportion of the crushed diamond particle mentioned herein refers to the proportion of the crushed diamond particle having a coating film in the entire diamond composite particle that is expressed in "% by volume."

The crushed diamond particle has a large specific surface area compared with the as-grown diamond particle, and when the crushed diamond particle is used, since the total surface area of a filler becomes large, and the contact area with a resin increases, the heat resistance is likely to deteriorate. Additionally, in the crushed diamond particle, a catalyst incorporated into the particle and used during synthesis (that is, an impurity) is exposed, and the heat resistance is likely to further deteriorate compared with that of the as-grown particle due to such an impurity. Therefore, in the case of using the crushed diamond particle, an effect of enhancing the heat resistance by forming the coating film becomes large. Furthermore, the crushed diamond particle ordinarily has a large specific surface area, and the viscosity of a resin composition is thus likely to increase, but the diamond composite particle has the coating film and is modified with a silane coupling agent, which will be described below, and is thereby capable of effectively curbing an increase in the viscosity.

<Average particle diameter>

The average particle diameter of the diamond composite particle of the present invention is preferably 1 μm or more and 80 μm or less. When having an average particle diameter of a certain value or less, the diamond composite particle is appropriately dispersed in a resin composition and can be contained at a high loading rate. In addition, when the diamond composite particle has an average particle diameter of the above-described lower limit value or more, it becomes easy to enhance the thermal conductivity of a resin composition. From these viewpoints, the average particle diameter of the diamond composite particle is more preferably 2 μm or more and 35 μm or less and still more preferably 4 μm or more and 25 μm or less.

The average particle diameter of the diamond composite particle is an average particle diameter obtained by averaging volume-based particle diameters and can be obtained by measuring the particle size distribution by, for example, a laser diffraction method. As a measuring instrument, for example, "laser diffraction-type particle size distribution measuring instrument" manufactured by Horiba, Ltd. can be used for the measurement. Regarding a method for calculating the average particle diameter, the particle diameter (d50) at which the cumulative volume is 50% may be regarded as the average particle diameter.

The diamond particle that configures the core is a particle that is used without being agglomerated in the case of using crystalline diamond synthesized by a high-temperature high-pressure method as described below or the like, and in that case, the above average particle diameter can also be said to be the average particle diameter of the primary particle of the diamond composite particle.

The diamond composite particle may be a diamond composite particle obtained by mixing two or more kinds of diamond composite particles having different average particle diameters as long as the entire average particle diameter is within the above-described range. In this case, the diamond composite particle can be determined to include two or more kinds of diamond composite particles having different average particle diameters from two or more peaks appearing in the particle size distribution.

In a case where the diamond composite particle includes two or more kinds of diamond composite particles having different average particle diameters, the average particle diameter of each diamond composite particle may be within a range of 1 μm or more and 80 μm or less and is preferably within a range of 2 μm or more and 35 μm or less and more preferably within a range of 4 μm or more and 25 μm or less.

The diamond particle that is used for the core of the diamond composite particle is typically synthetic diamond and preferably a crystalline diamond particle.

The synthetic diamond particle may be synthesized by a detonation method or synthesized by a high-temperature high-pressure method, but is preferably synthesized by a high-temperature high-pressure method. When synthesized by the high-temperature high-pressure method, the diamond particle does not agglomerate, and a diamond particle having a large average particle diameter of the primary particle can be obtained. In addition, synthesis by the high-temperature high-pressure method makes it easy to obtain a crystalline diamond particle.

In the high-temperature high-pressure method, practically, the synthetic diamond particle can be synthesized by crystallizing a carbon material such as graphite in the presence of at least one metal catalyst selected from the group consisting of iron, nickel, cobalt and chromium, preferably in the presence of an iron catalyst, at a high temperature and a high pressure. The diamond particle thus synthesized ordinarily becomes spherical. In addition, the diamond particle synthesized by crystallization at a high temperature and a high pressure is preferably crushed as appropriate as necessary to be made into a crushed diamond particle as described above. On the diamond particle synthesized by the high-temperature high-pressure method, a cleaning treatment such as acid cleaning, or a reduction treatment using a hydrogen

gas or the like is performed as necessary.

[Resin composition]

The diamond composite particle of the present invention may be used after being composited with a resin and is preferably used in a resin composition, specifically after being blended with a base resin. The diamond composite particle of the present invention has the coating film containing the metal oxide and has a thickness of the coating film and the standard deviation/average thickness both in the predetermined ranges and is thus excellent in terms of thermal conductivity and heat resistance when composited with a resin. Therefore, when the diamond composite particle is blended with a resin composition, it is possible to obtain a resin composition having excellent thermal conductivity and heat resistance.

The content of the diamond composite particle in the resin composition is preferably 10% by mass or more and 99% by mass or less, more preferably 30% by mass or more and 95% by mass or less and still more preferably 50% by mass or more and 90% by mass or less based on 100% by mass of the resin composition.

When the resin composition contains the diamond composite particle in a certain content or more, it becomes easy to make the thermal conductivity favorable. In addition, when the resin composition contains the diamond composite particle in a content of a certain value or less, it is possible to appropriately disperse the diamond composite particle in the composition and also to prevent the viscosity from becoming higher than necessary.

<Resin>

The base resin that is used in the resin composition serves as a component that holds the diamond composite particle. The base resin may be a curable resin, a thermoplastic resin or the like. In addition, the base resin may be an elastomer resin. The curable resin may be any of moisture-curable, thermosetting or photocurable, but is preferably thermosetting. The base resin may be a liquid-phase component or a solid-phase component. The liquid-phase component resin may cure and thereby turn into a solid or may be non-curable and remains in a liquid phase in the heat radiation member. The liquid-phase component refers to a component that is a liquid phase at room temperature (25°C) and normal pressure (one atmosphere).

Specific examples of the base resin include a silicone resin, an epoxy resin, an acrylic resin, a urethane resin, a phenol resin, a polyester resin, a polyolefin resin and the like.

In addition, the base resin may be an elastomer resin and specific examples thereof include ethylene-propylene-diene rubber, ethylene-propylene rubber, natural rubber, polyisoprene rubber, a polyester-based thermoplastic elastomer, a polyurethane-based thermoplastic elastomer, a styrene-based thermoplastic elastomer, an olefin-based thermoplastic elastomer and the like. The elastomer resin may be a liquid phase or a solid phase.

One base resin may be used singly or two or more base resins may be jointly used.

Among what has been listed above, the base resin preferably contains at least one selected from the group consisting of a silicone resin, an epoxy resin, a polyolefin resin and an acrylic resin, more preferably contains at least one selected from the group consisting of a silicone resin and an epoxy resin and still more preferably contains a silicone resin.

(Silicone resin)

Specific examples of the silicone resin include a curing-type silicone resin. The curing-type silicone resin may be any of a condensation curing-type silicone resin or an addition reaction curing-type silicone resin, but is preferably an addition reaction curing-type silicone resin. In addition, the silicone resin is also preferably silicone rubber.

The addition reaction curing-type silicone resin is preferably composed of a silicone compound that serves as a main agent and a curing agent that cures the main agent. The silicone compound that is used as a main agent is preferably an organopolysiloxane having an alkenyl group and more preferably an organopolysiloxane having a vinyl group. The number of the alkenyl groups in one molecule of the organopolysiloxane is preferably two or more, and the alkenyl groups are more preferably contained at both ends.

Specific examples of the organopolysiloxane having a vinyl group include organopolysiloxanes having vinyl at both ends such as polydimethylsiloxane having vinyl at both ends, polyphenylmethylsiloxane having vinyl at both ends, a dimethylsiloxane-diphenylsiloxane copolymer having vinyl at both ends, a dimethylsiloxane-phenylmethylsiloxane copolymer having vinyl at both ends and a dimethylsiloxane-diethylsiloxane copolymer having vinyl at both ends.

The curing agent that is used in the addition reaction curing-type silicone resin is not particularly limited as long as the above curing agent is capable of curing the silicone compound, which is the above-described main agent, but is preferably organohydrogenpolysiloxane, which is an organopolysiloxane having two or more hydrosilyl groups (SiH) in one molecule. The ratio (mole ratio) of the hydrosilyl groups to the vinyl group in the silicone compound is preferably 0.3 or more and 5 or less, more preferably 0.4 or more and 4 or less and still more preferably 0.6 or more and 4 or less. In the resin

composition where the diamond composite particle is used, there are cases where a reaction between the main agent and the curing agent does not proceed due to the diamond composite particle; however, when the mole ratio is 0.6 or more, the reaction sufficiently proceeds, and it becomes possible to obtain a sufficiently cured heat radiation member.

The silicone resin has a viscosity at 25°C of preferably 5 mPa·s or more and 1000 mPa·s or less, more preferably 30 mPa·s or more and 700 mPa·s or less and still more preferably 50 mPa·s or more and 600 mPa·s or less.

The viscosity of the silicone resin may be measured using a rotor with a spindle No. 14 in a viscometer (Brookfield digital viscometer DV-E) at a rotation speed of 5 rpm and a measurement temperature of 25°C. In a case where the silicone resin has the main agent and the curing agent as described above, the viscosity at 25°C of a mixture of the main agent and the curing agent may be within the above-described range, but the viscosity at 25°C of each of the main agent and the curing agent may be within the above-described range.

When the viscosity range of the silicone resin is set within the above-described range, the resin composition is provided with a viscosity within a predetermined range, whereby it is possible to hold the resin composition in a certain shape after being applied while making the applicability of the resin composition favorable, which makes it possible for the resin composition to be easily disposed on an electronic component or the like. In addition, it becomes easy to blend a large amount of the diamond composition after dispersing the diamond composite particle as appropriate.

In a case where the addition reaction curing-type silicone resin is used as the silicone resin, normally, a curing catalyst is blended into the resin composition. Examples of the curing catalyst include a platinum-based catalyst, a palladium-based catalyst, a rhodium-based catalyst and the like. The curing catalyst is a catalyst for curing the silicone compound and the curing agent, which serve as the raw materials of the silicone resin. The amount of the curing catalyst blended is normally 0.1 to 200 ppm and preferably 0.5 to 100 ppm based on the total mass of the silicone compound and the curing agent.

In a case where the addition reaction curing-type silicone resin is used as the silicone resin, a cure retarder may be blended into the resin composition. A well-known cure retarder can be used as the cure retarder, and examples thereof include acetylene compounds such as 1-ethynyl-1-cyclohexanol and 3,5-dimethyl-1-hexyn-3-ol, a variety of nitrogen compounds such as tributylamine and tetramethylethylenediamine, organic phosphorus compounds such as triphenylphosphine, oxime compounds, and organic chloro compounds and the like. When the cure retarder is contained to curb the catalytic activity or the like of the curing catalyst, it is possible to extend the shelf life and pot life of the resin composition.

The content of the cure retarder in the resin composition is preferably 0.01 parts by mass or more and 2 parts by mass or less and more preferably 0.1 parts by mass or more and 1 part by mass or less based on 100 parts by mass of the silicone resin.

In the case of using the addition reaction curing-type silicone resin, the resin composition may be a one-liquid curing type or a two-liquid curing type, and in the case of a two-liquid curing type, the resin composition is preferably cured by mixing a first liquid containing the main agent and a second liquid containing the curing agent.

In addition, the silicone resin may also be a silicone oil. Examples of the silicone oil include methylphenyl silicone oil, dimethyl silicone oil, modified silicone oil and the like. The silicone oil has, for example, a viscosity at 25°C of preferably 5 mPa·s or more and 1000 mPa·s or less, more preferably 30 mPa·s or more and 700 mPa·s or less and still more preferably 50 mPa·s or more and 600 mPa·s or less.

The silicone oil is a liquid phase at room temperature under normal pressure when blended and is a liquid-phase or gel-phase component when used. That is, the silicone oil is a substantially non-curable substance that is not cured by a curing agent or the like and, even when cured, turns into a liquid phase or a gel phase after cured. Therefore, when the silicone oil is used singly or in a relatively large blending portion as the base resin, it is possible form a heat radiation member in a paste phase from the resin composition.

The silicone oil that is contained in the resin composition has a viscosity at 25°C of preferably 5 mPa·s or more and 1000 mPa·s or less, more preferably 30 mPa·s or more and 700 mPa·s or less and still more preferably 100 mPa·s or more and 600 mPa·s or less. When the viscosity range of the silicone oil is set within the above-described range, the resin composition is provided with a viscosity within a predetermined range, whereby it is possible to hold the resin composition in a certain shape after being applied while making the applicability of the resin composition favorable, which makes it possible for the resin composition to be easily disposed on an electronic component or the like. In addition, it becomes easy to blend a large amount of the diamond composition after dispersing the diamond composite particle as appropriate.

The viscosity of the silicone resin may be measured using a rotor with a spindle No. 14 in a viscometer (Brookfield digital viscometer DV-E) at a rotation speed of 5 rpm and a measurement temperature of 25°C.

In a case where the resin composition is a curable type, as described above, the resin composition may be a one-liquid curing type or a two-liquid curing type. In the case of a two-liquid curing type, the resin composition may be obtained by mixing a first liquid containing a silicone resin that serves as the main agent and a second liquid containing a silicone resin that serves as the curing agent. Therefore, in a case where the silicone resin is a curing type such as a one-liquid curing type or a two-liquid curing type, the resin composition preferably contains both an organopolysiloxane having an alkenyl group and an organohydrogenpolysiloxane.

In addition, the curing-type resin composition may contain a non-curable organopolysiloxane as the silicone resin

and may contain, for example, in addition to the organopolysiloxane having an alkenyl group or organopolysiloxane having a hydrosilyl group, a silicone oil or the like. It is needless to say that the resin composition may be a non-curing-type silicone resin composition and, in such a case, for example, a silicone oil may be used singly as the silicone resin.

(Epoxy resin)

As the epoxy resin that is used as the resin, an epoxy compound having at least one epoxy group, preferably two or more epoxy groups, is used. The epoxy compound is a curable resin and is normally a thermosetting resin.

Examples of the epoxy compound include bisphenol-type, novolac-type, naphthalene-type, triphenolalkane-type, biphenyl-type and cycloaliphatic epoxy compounds, halides thereof, hydrogenated products thereof and the like.

In addition, the epoxy compound may also be used singly as the epoxy resin, but a resin containing the above epoxy compound as a main agent to which a curing agent is further added is used as the epoxy resin. As the curing agent, a heavy addition-type or catalyst-type curing agent is used. Examples of the heavy addition-type curing agent include a polyamine-based curing agent, an acid anhydride-based curing agent, a polyphenol-based curing agent, polymercaptan, dicyandiamide and the like. In addition, examples of the above catalyst-type curing agent include tertiary amines, imidazoles, Lewis acid complexes and the like. These may be used singly or two or more thereof may be jointly used.

In addition, in the case of using the epoxy resin, the resin composition is preferably a two-liquid curing-type and is preferably cured by mixing a first liquid containing the main agent and a second liquid containing the curing agent.

(Polyolefin resin)

Examples of the polyolefin resin include a polyethylene resin, a polypropylene resin, a poly(1-)butene resin, a polypentene resin and the like. Among these, a polyethylene resin and a polypropylene resin are preferable.

The polyethylene resin is not particularly limited, and examples thereof include low-density polyethylene, medium-density polyethylene, high-density polyethylene, linear low-density polyethylene and the like. Examples of the linear low-density polyethylene include ethylene/$\alpha$-olefin copolymers such as an ethylene/1-butene copolymer, an ethylene/1-hexene copolymer, an ethylene/4-methyl-1-pentene copolymer and an ethylene/1-octene copolymer.

The polypropylene resin is not particularly limited, and examples thereof include propylene homopolymers (homopolypropylenes) and copolymers of propylene and a different olefin. The copolymers of propylene and a different olefin may be any of a block copolymer, a random copolymer or a random block copolymer and is preferably a random copolymer (random polypropylene).

Examples of the different olefin that is copolymerized with propylene include $\alpha$-olefins such as ethylene, 1-butene, 1-pentene, 4-methyl-1-pentene, 1-hexene, 1-octene, 1-nonene and 1-decene, and among these, ethylene is preferable. Therefore, an ethylene-propylene random copolymer is more preferable. A configuration unit derived from the different olefin in the polypropylene resin may be, for example, 10% by mass and is preferably 1 to 8% by mass and more preferably 2 to 6% by mass.

(Acrylic resin)

As the acrylic resin that is used as the base resin, for example, a photocurable resin is used. The acrylic resin may be a component that configures an acrylic polymer by being cured, and examples thereof include a variety of acrylic compounds such as (meth)acrylates such as alkyl (meth)acrylates and hydroxyalkyl (meth)acrylates, (meth)acrylic acid, (meth)acrylamides, and urethane (meth)acrylates. In addition, a vinyl monomer or the like that can be copolymerized with the acrylic compounds may be contained.

In the resin composition, the content of the base resin is preferably 0.7% by mass or more and 85% by mass or less, more preferably 3% by mass or more and 65% by mass or less and still more preferably 5% by mass or more and 45% by mass or less based on 100% by mass of the resin composition. When the content of the base resin is these lower limit values or more, it is possible to hold the diamond composite particle dispersed in the resin with the base resin, and the resin composition is made to be capable of maintaining a constant shape. In addition, when the content is set to these upper limit values or less, it is possible to blend a certain amount or more of the diamond composite particle into the resin composition.

<Other inorganic particle>

The resin composition may further contain an inorganic particle other than the diamond composite particle (hereinafter, also referred to as "other inorganic particle"). When the other inorganic particle is contained, the loading rate of all inorganic particles is increased, and the thermal conductivity is increased, which makes it possible to enhance the heat radiation properties. As the other inorganic particle, a thermally conductive filler having high thermal conductivity and being capable of increasing the thermal conductivity of the resin composition is preferably used. The thermal conductivity

of the other inorganic particle is preferably 8 W/(m·K) or more, more preferably 15 W/(m·K) or more and still more preferably 25 W/(m·K) from the viewpoint of enhancing the thermal conductivity. The thermal conductivity can be measured from, for example, a cross section of the inorganic particle cut with a cross section polisher using a thermal microscope manufactured by Bethel Co., Ltd. by a periodic heating and thermoreflectance method.

In addition, as the other inorganic particle, a material having a low electric conductivity is preferably used from the viewpoint of the insulating properties. Examples of the other inorganic particle include carbides, nitrides, oxides, hydroxides, carbon-based materials other than diamonds and the like.

Examples of the carbides include silicon carbide, boron carbide, aluminum carbide, titanium carbide, tungsten carbide and the like. Examples of the nitrides include silicon nitride, boron nitride, aluminum nitride, gallium nitride, chromium nitride, tungsten nitride, magnesium nitride, molybdenum nitride, lithium nitride and the like.

Examples of the oxides include iron oxide, silicon oxide (silica), alumina, aluminum oxide such as boehmite, magnesium oxide, titanium oxide, cerium oxide, zirconium oxide and the like. The oxides may be the same as or different from the metal oxide that is contained in the coating film that configures the diamond composite particle.

Examples of the hydroxides include aluminum hydroxide, calcium hydroxide, magnesium hydroxide and the like. Examples of the carbon-based materials include carbon black, graphite, graphene, fullerene, carbon nanotube, carbon nanofiber and the like. In addition, the carbon-based material may be a diamond particle other than the diamond particle that configures the diamond composite particle of the present invention. In addition, talc, which is a silicate material, can also be used.

These other inorganic particles may be used singly or two or more thereof may be jointly used.

The average particle diameter of the other inorganic particle is preferably preferably smaller than the average particle diameter of the diamond composite particle described above. When the average particle diameter of the other inorganic particle is decreased, it is possible to more appropriately pack the other inorganic particle into between the diamond composite particles, and thermal conduction between the diamond composite particles is thus accelerated, whereby the thermal conductivity enhances.

The average particle diameter of the other inorganic particle is, for example, 50 μm or less, preferably 25 μm or less, more preferably 20 μm or less and still more preferably 15 μm or less from the viewpoint of making it easy to appropriately pack the other inorganic particle into between the diamond composite particles and thereby enhance the thermal conductivity.

In addition, the lower limit of the average particle diameter of the other inorganic particle is not particularly limited, but is, for example, 0.1 μm or more, preferably 0.5 μm or more, more preferably 1 μm or more and still more preferably 3 μm or more. When the average particle diameter of the other inorganic particle is set to be the above-described lower limit value or more, it becomes easy to prevent an increase in the viscosity or the like while maintaining the thermal conductivity of the resin composition to be high.

As the other inorganic particle, two or more kinds of inorganic particles having different average particle diameters may be jointly used. The other inorganic particle can be determined to include two or more kinds of inorganic particles having different average particle diameters from the appearance of two or more peaks in the particle size distribution.

In a case where the other inorganic particle includes two or more kinds of inorganic particles having different average particle diameters, the average particle diameter of each inorganic particle may be within a range of 0.1 μm or more and 100 μm or less and is preferably within a range of 0.2 μm or more and 50 μm or less and more preferably within a range of 0.4 μm or more and 25 μm or less.

The shape of the other inorganic particle is not particularly limited and may be any of a plate-like shape, a scaly shape, a needle-like shape, a fibrous shape, a tubular shape, a spherical shape, a crushed shape, a polygonal shape, an irregular shape or the like, but is preferably a spherical shape or a shape similar to a spherical shape. When the other inorganic particle has a spherical shape or a shape similar to a spherical shape, it becomes easy to increase the loading rate. Specifically, the sphericity of the other inorganic particle may be, for example, 0.5 or more, preferably 0.55 or more and still more preferably 0.6 or more. In addition, the upper limit of the sphericity is not particularly limited and is one.

The sphericity of the inorganic particle can be obtained from an average value that is obtained by confirming the electron micrograph of the inorganic particle and calculating (the diameter of a circle that is equal to the projected area of the particle/the diameter of a minimum circle that circumscribes the projected area of the particle) for 300 particles in the obtained image.

In a case where the resin composition contains the other inorganic particle, the loading rate of the other inorganic particle may be adjusted as appropriate so that the total loading rate of the inorganic particles is within a range to be described below and is preferably 50% by volume or less, more preferably 40% by volume or less and still more preferably 35% by volume or less. When the loading rate is set to these upper limit values or less, it is possible to blend a certain amount or more of the diamond composite particle into the resin composition, and it thus becomes easy to enhance the thermal conductivity. In addition, the loading rate of the other inorganic particle is preferably 2% by volume or more, more preferably 10% by volume or more and still more preferably 15% by volume or more. When the loading rate is set to these

lower limit values or more, it becomes easy to exhibit the effect of the other inorganic particle blended.

The total loading rate of the inorganic particles (that is, the total of the loading rates of the diamond composite particle and the other inorganic particle) is, for example, 28% by volume or more, preferably 40% by volume or more, more preferably 45% by volume or more, still more preferably 60% by volume or more, far still more preferably 70% by volume or more and particularly preferably 80% by volume or more. When the loading rate of the inorganic particles is set to these lower limit values or more, it is possible to increase the thermal conductivity. In addition, when the other inorganic particle is jointly used together with the diamond composite particle, it is also possible to make the resin composition highly packed (60% by volume or more). When the resin composition is highly packed (60% by volume or more), the inorganic particles in the composition come into contact with each other (percolate), and the thermal conductivity becomes particularly favorable.

The total loading rate of the inorganic particles is, for example, 94% by volume or less, preferably 92% by volume or less and more preferably 90% by volume or less. When the total loading rate is set to these lower limit values or more, it is possible to increase the thermal conductivity. In addition, when the total loading rate is set to these upper limit values or less, it becomes easy to appropriately disperse the inorganic particles in the resin.

In a case where the resin composition contains the other inorganic particle, the loading rate of the other inorganic particle is preferably 1% by volume or more, more preferably 2% by volume or more and still more preferably 3% by volume or more and is preferably 70% by volume or less, more preferably 60% by volume or less, still more preferably 50% by volume or less and far still more preferably 45% by volume or less based on all of the inorganic particles (that is, when the total of the diamond composite particle and the other inorganic particle is set to 100% by volume) from the viewpoint of the insulating properties and the thermal conductivity.

<Dispersant>

The resin composition of the present invention preferably contains a dispersant having a different structure from the base resin. The use of the dispersant enhances the wettability of the diamond composite particle, which makes it easy to disperse the diamond composite particle in the base resin. Therefore, it is possible to maintain the viscosity of the resin composition to be low and to enhance the thermal conductivity.

A silane coupling agent is preferably contained as the dispersant, and specific examples thereof include silicone compounds having polar groups at end(s) thereof. Here, examples of the polar group include an alkoxy group, a hydroxyl group and the like, and an alkoxy group is preferable. The polar group preferably bonds to a Si atom, and the polar group is thus preferably a hydrolysable silyl group such as a silanol group or an alkoxysilyl group and more preferably an alkoxysilyl group.

The silicone compounds having polar groups at end(s) thereof are preferably used in a case where the base resin is a silicone resin.

When the resin composition contains the silicone compound having polar groups at end(s) thereof as the dispersant, the polar groups in the dispersant bond to or interact with a hydrophilic functional group X in the diamond composite particle to make it possible to facilitate dispersion of the diamond composite particle in the base resin. Particularly, it is easy for the alkoxy group to be hydrolyzed to react with the hydrophilic functional group X and to make it easy to enhance the dispersibility of the diamond composite particle.

In addition, the use of the silicone compound as the dispersant makes it particularly easy for the diamond composite particle to fit into the base resin at the time of using the silicone resin as the base resin and makes it easy to increase the volume rate of the diamond composite particle in the resin composition.

The silicone compound having polar groups at end(s) thereof is preferably an organopolysiloxane having a hydrolysable silyl group at a molecular chain end (hereinafter, also referred to as the organopolysiloxane (X)). The organopolysiloxane (X) may be a straight chain or a branched chain or may be a mixture of a straight chain and a branched chain, but is preferably a straight chain. In addition, the organopolysiloxane (X) is preferably an organopolysiloxane having at least one hydrolysable silyl group at a molecular chain end, more preferably an organopolysiloxane having at least one hydrolysable silyl group only at one end and still more preferably an organopolysiloxane having three hydrolysable silyl groups at one end. Here, the hydrolysable silyl group is more preferably an alkoxysilyl group and still more preferably a methoxysilyl group.

The organopolysiloxane (X) has a hydrolysable silyl group at the end and is thus likely to react or interact with the functional group present on the surface of the diamond composite particle. In addition, the dispersibility of the diamond composite particle also becomes favorable in combination with the polysiloxane structure.

Specifically, the organopolysiloxane (X) is preferably a compound represented by the following formula (1).

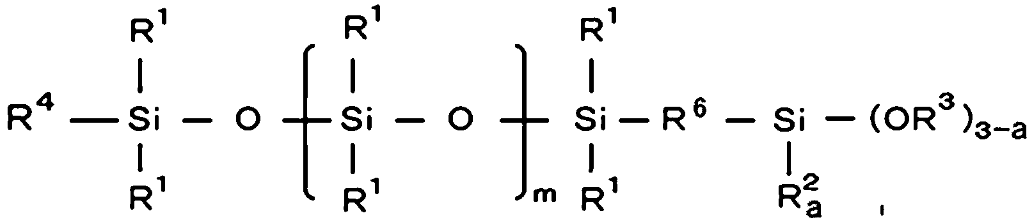 (1)

In the formula (1), $R^1$'s are each independently any of an alkyl group having 1 to 20 carbon atoms, an alkyl halide group having 1 to 20 carbon atoms, an aryl group having 6 to 20 carbon atoms or an aralkyl group having 7 to 20 carbon atoms, and the plurality of $R^1$'s may be the same as or different from each other. $R^2$'s are each independently an alkyl group having 1 to 4 carbon atoms, and in a case where there are multiple $R^2$'s, these $R^2$'s may be the same as or different from each other. $R^3$'s are each independently any of an alkyl group having 1 to 4 carbon atoms, an alkoxyalkyl group having 2 to 4 carbon atoms or an acyl group having 2 to 4 carbon atoms, and in a case where there are multiple $R^3$'s, these $R^3$'s may be the same as or different from each other. $R^4$ is an alkyl group having 1 to 8 carbon atoms. $R^6$ is an oxygen atom or a divalent organic group having 1 to 40 carbon atoms. The character of m is an integer of 3 to 315. In the formula (1), the character of a is an integer of 0 to 2.

In the formula (1), the alkyl group in $R^1$ may be a straight chain or a branched chain and may have a cyclic structure. More preferable examples thereof include straight chain alkyl groups such as a methyl group, an ethyl group, a propyl group, a butyl group, a pentyl group, a hexyl group, a heptyl group, an octyl group, a nonyl group, a decyl group, a undecyl group, a dodecyl group, a tridecyl group, a tetradecyl group, a pentadecyl group, a hexadecyl group, a heptadecyl group, an octadecyl group, a nonadecyl group and an eicosyl group, branched chain alkyl groups such as an isopropyl group, a tertiary butyl group, an isobutyl group, a 2-methylundecyl group and a 1-hexylheptyl group and cyclic alkyl groups such as a cyclopentyl group, a cyclohexyl group and a cyclododecyl group.

Examples of the alkyl halide group include a chloromethyl group, a 3,3,3-trifluoropropyl group, a 3-chloropropyl group and the like. Examples of the aryl group include a phenyl group, a tolyl group, a xylyl group and the like. Examples of the aralkyl group include a benzyl group, a phenethyl group, a 2-(2,4,6-trimethylphenyl)propyl group and the like.

Among these, $R^1$ is preferably an alkyl group having 1 to 20 carbon atoms, more preferably an alkyl group having 1 to 4 carbon atoms and still more preferably a methyl group. In the compound of the formula (1), 80% or more of $R^1$'s are preferably methyl groups, 90% or more are more preferably methyl groups and all of $R^1$'s are still more preferably methyl groups.

In the formula (1), $R^2$ is an alkyl group having 1 to 4 carbon atoms, and in a case where there are multiple $R^2$'s (that is, a case where a is 2), these $R^2$'s may be the same as or different from each other. In addition, the alkyl group may be a straight chain or a branched chain. Among these, $R^2$ is preferably an alkyl group having 1 or 2 carbon atoms and more preferably a methyl group. In addition, a is an integer of 0 to 2, and a is preferably 0 or 1 and more preferably 0.

In the formula (1), $R^3$ is an alkyl group having 1 to 4 carbon atoms, an alkoxyalkyl group having 2 to 4 carbon atoms or an acyl group having 2 to 4 carbon atoms, and in a case where there are multiple $R^3$'s (that is, a case where a is 0 or 1), these $R^3$'s may be the same as or different from each other. In addition, the alkyl group, alkoxyalkyl group or acyl group in $R^3$ may be a straight chain or a branched chain. Among these, $R^3$ is preferably an alkyl group having 1 to 4 carbon atoms and, among these, more preferably a methyl group.

In the formula (1), $R^4$ is an alkyl group having 1 to 8 carbon atoms, preferably an alkyl group having 2 to 6 carbon atoms and more preferably a butyl group.

In the formula (1), $R^6$ is preferably a group represented by the following formula (2), an oxygen atom or a divalent hydrocarbon group having 1 to 20 carbon atoms and more preferably a group represented by the following formula (2) or a divalent hydrocarbon group having 1 to 20 carbon atoms. Here, the divalent hydrocarbon group having 1 to 20 carbon atoms is preferably an alkylene group, and the alkylene group may be a straight chain or a branched chain. The divalent hydrocarbon group having 1 to 20 carbon atoms is preferably an alkylene group having 2 to 10 carbon atoms, more preferably an alkylene group having 2 to 8 carbon atoms and still more preferably an alkylene group having 2 to 4 carbon atoms, examples thereof include a methylene group, an ethylene group, a propylene group, a butylene group, a methylethylene group and the like, and among these, an ethylene group is preferable.

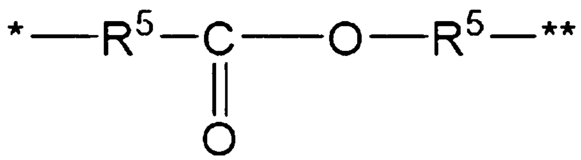 (2)

In the formula (2), $R^5$ is a divalent hydrocarbon group having 1 to 20 carbon atoms, and the plurality of $R^5$'s may be

the same as or different from each other. The mark of * is a bonding site to a silicon atom in $R^1$-Si-$R^1$. The mark of ** is a bonding site to a silicon atom in $SiR^2_a(OR^3)_{3-a}$.

The divalent hydrocarbon group in $R^5$ is preferably an alkylene group, and the alkylene group may be a straight chain or a branched chain. $R^5$ is preferably an alkylene group having 2 to 10 carbon atoms, more preferably an alkylene group having 2 to 8 carbon atoms, still more preferably an alkylene group having 2 to 4 carbon atoms and far still more preferably an alkylene group represented by $-CH_2-CH_2-CH_2-$ or $-CH(CH_3)-CH_2-$.

m in the formula (1) represents the number of repetitions and is an integer of 3 to 315, preferably an integer of 4 to 280, more preferably an integer of 5 to 220 and still more preferably an integer of 5 to 100.

As the dispersant, a non-silicone compound dispersant can also be used, and a polymer-based dispersant other than the silicone compound can be used. Examples of a polymer-based dispersant to be used include polymer compounds having a functional group. Examples of the polymer compounds include an acrylic compound, a vinyl-based compound, a polyester-based compound, a polyurethane-based compound, a polyether-based compound, an epoxy-based compound, a polystyrene-based compound, an amino-based compound and the like. In addition, examples of the functional group include a carboxyl group, a phosphate group, a sulfonic acid group, a carboxylic acid ester group, a phosphoric acid ester group, a sulfonic acid ester group, a hydroxyl group, an amino group, a quaternary ammonium base, an amide group and the like, and a phosphoric acid ester group is preferable.

The polymer-based dispersant other than the silicone compound is preferably used when the base resin contains, for example, a resin other than the silicone-resin such as an epoxy resin or an acrylic resin.

The above-described polymer-based dispersant makes it easy to disperse a coating particle in the base resin due to the bonding or interaction of the above functional group to or with the hydrophilic functional group X in the diamond composite particle. In addition, the polymer-based dispersant is a polymer compound other than the silicone compound, which makes it particularly easy for the diamond composite particle to fit into the base resin at the time of using a resin component other than the silicone resin (for example, an epoxy resin or an acrylic resin) as the base resin and makes it easy to increase the volume rate of the diamond composite particle in the resin composition.

In addition, as the dispersant, a dispersant other than the polymer-based dispersant can also be used, and for example, an alkoxysilane compound can also be used. The alkoxysilane compound is a compound having a structure in which, out of the four bonds of a silicon atom (Si), one to three bond to alkoxy groups and the remaining bonds bond to an organic substituent. An alkoxy group in the alkoxysilane compound is a hydrolysable group, examples thereof include a methoxy group, an ethoxy group, a protoxy group, a butoxy group, a pentoxy group and a hexatoxy group, and among these, an alkoxysilane compound having a methoxy group or an ethoxy group is preferable.

The number of the alkoxy groups in the alkoxysilane compound is preferably three from the viewpoint of enhancing the affinity to the inorganic particle such as the diamond composite particle. Therefore, the alkoxysilane compound is more preferably at least one selected from the group consisting of a trimethoxysilane compound and a triethoxysilane compound.

Examples of a functional group that is contained in the organic substituent of the alkoxysilane compound include an acryloyl group, an alkyl group, a carboxyl group, a vinyl group, a methacrylic group, an aromatic group, an amino group, an isocyanate group, an isocyanurate group, an epoxy group, a hydroxyl group, a mercapto group and the like.

The alkoxysilane compound is preferably an alkylalkoxysilane compound having an alkyl group bonding to a silicon atom from the viewpoint of making it easy to fit into the silicone resin and enhancing the dispersibility of the inorganic particle such as the diamond composite particle. The number of carbon atoms in the alkyl group bonding to a silicon atom is preferably four or more. In addition, the number of carbon atoms in the alkyl group bonding to a silicon atom is preferably 16 or less from the viewpoint of a relatively low viscosity of the alkoxysilane compound itself and the viscosity of the resin composition being curbed to be low.

Examples of the preferable alkylalkoxysilane compound include n-hexyltrimethoxysilane, n-hexyltriethoxysilane, n-octyltriethoxysilane and n-decyltrimethoxysilane.

In addition, examples of the alkoxysilane compounds other than the alkylalkoxysilane compound include 3-acryloxypropyltrimethoxysilane, 3-methacryloxypropyltrimethoxysilane, 3-isocyanatepropyltriethoxysilane, 3-(2-aminoethyl)aminopropyltrimethoxysilane, 3-mercaptopropyltrimethoxysilane, glycidoxypropyltrimethoxysilane, 3-phenylaminopropyltrimethoxysilane and the like.

As the dispersant, one of the above-described dispersants may be used singly or two or more thereof may be jointly used.

The content of the dispersant in the resin composition is preferably 0.1% by mass or more and 5% by mass or less, more preferably 0.5% by mass or more and 4.5% by mass or less and still more preferably 1% by mass or more and 4% by mass or less based on the total amount of the resin composition. When the content is set to these lower limit values or more, it is possible to approximately disperse the inorganic particle such as the diamond composite particle in the resin composition, and composition becomes easy. In addition, when the content is set to these upper limit values or less, it is possible to impart dispersibility commensurate with the content.

<Other additives>

In the case of being a curing type, the resin composition may preferably contain a curing catalyst. For example, in the case of using the addition reaction curing-type silicone resin, examples of the curing catalyst include a platinum-based catalyst, a palladium-based catalyst, a rhodium-based catalyst and the like. These curing catalysts are catalysts for curing the silicone resin that serves as the main agent and the silicone resin that serves as the curing agent. The mass-based amount of the curing catalyst blended is normally 0.1 to 200 ppm and preferably 0.5 to 100 ppm based on the silicone resin. In the case of a two-liquid curing type, the curing catalyst is preferably blended into the first liquid containing the main agent, but may also be contained in the second liquid containing the curing agent.

The resin composition of the present invention may contain an additive that is ordinarily used in heat radiation members such as an antioxidant, a heat stabilizer, a colorant, a flame retardant or an antistatic agent as necessary. In addition, in a case where a curable resin such as a thermosetting resin is used, the resin composition may contain a reaction inhibitor. When the reactive inhibitor is contained, and the catalytic activity or the like of the curing catalyst is curbed, it is possible to extent the shelf life and pot life of the resin composition. In addition, in the case of using a photocurable resin, the resin composition may contain a photopolymerization initiator.

<Physical properties of resin composition>

The resin composition of the present invention contains the diamond composite particle, whereby the thermal conductivity becomes high, and the thermal conductivity becomes favorable. The thermal conductivity of the resin composition is preferably 1.2 W/(m·K) or more, more preferably 1.25 W/(m·K) or more and still more preferably 1.30 W/(m·K) or more. In addition, as the thermal conductivity of the resin composition increases, the heat radiation properties become superior; however, practically, the thermal conductivity may be, for example, 25 W/(m·K) or less.

In addition, when the weight loss rate is curbed, the resin composition of the present invention is capable of enhancing the heat resistance. The weight loss rate of the resin composition is preferably 1% or less and more preferably 0.7% or less. As the weight loss rate becomes lower, it is possible to further enhance the heat resistance, and the weight loss rate may be 0% or more.

Both the thermal conductivity and the weight loss rate can be measured by methods to be described in Examples.

[Preparation of resin composition]

The resin composition of the present invention may be prepared by mixing the base resin, the diamond composite particle, furthermore, the other inorganic particle that is blended as necessary, a silane coupling agent, other additives or the like. In the case of producing a two-liquid curing-type resin composition, the resin composition may be prepared by mixing a first liquid and a second liquid that have been prepared in advance as described above. The first liquid and the second liquid may also be prepared by mixing a variety of components in the same manner.

In addition, the diamond composite particle may be surface-treated with a silane coupling agent in advance, and in that case, the surface-treated diamond composite particle may be mixed with the base resin or the like.

[Heat radiation member]

The resin composition may be used as a heat radiation member. The heat radiation member is formed of the resin composition, and in a case where the resin composition is a curing type, it becomes possible to obtain a heat radiation member molded into a predetermined shape by molding the above resin composition in the predetermined shape or the like and then curing the resin composition as appropriate by heating or the like.

In addition, in a case where the resin composition is not a curing type, the resin composition may be molded into a predetermined shape and made into a heat radiation member. In the case of using the resin composition as a heat radiation member, the resin composition may be used after being molded into a thin film shape, a sheet shape, a block shape, an irregular shape or the like by coating, casting, potting, extrusion molding or the like and appropriately cured as necessary.

A heat radiation member of the present invention is used in, for example, electronic devices. The heat radiation member of the present invention has favorable thermal conductivity and is thus capable of securing high heat radiation properties even in a case where the amount of heat generated is large by being used in electronic devices. The heat radiation member is, for example, disposed on an electronic component and used to radiate heat generated from the electronic component. In addition, the heat radiation member of the present invention may also be used by being disposed so as to fill a gap between two facing members. The two facing members may be, for example, an electronic component as one member and any of a heat sink for dissipating heat from the electronic component, a chassis, a substrate or the like of an electronic device as the other member. The heat radiation member may also be used as so-called TIM (thermal interface material).

Examples

Hereinafter, the present invention will be described in more detail using Examples, but the present invention is not limited to these Examples by any means.

[Variety of Physical Properties]

The variety of physical properties were measured and evaluated by the following methods.

(Method for forming coating film)

A coating film was formed by any method of an ALD method, a sol-gel method or a CVD method, and a diamond composite particle was obtained. These film forming procedures are each as described below.

<ALD method>

A film was formed by the ALD method in a procedure described in the following (1) to (4). The ALD method was performed under conditions to be described below.

(1) A diamond particle was dried in advance under conditions of 250°C and six hours.
(2) 100 g of the diamond particle was put into a reactor, trimethylaluminum (TMA) vaporized in advance was supplied as a precursor to a reaction chamber of an ALD device (product name: PROMETHEUS, manufactured by Forge Nano Inc.) together with a nitrogen gas, which was a carrier gas, and a hydroxyl group on the surface of the particle and TMA were reacted with each other. The flow rate of the nitrogen gas at this time was 10 to 100 sccm.
(3) After the reaction of the above (2) was completed, TMA that did not react with the hydroxyl group was purged from the reaction chamber, after that, water vapor was supplied into the reaction chamber as a new precursor, and the group remaining after the completion of the reaction of the above (2) was hydrolyzed.
(4) After the hydrolysis of the above (3) was completed, methane generated as a by-product of the hydrolysis and water vapor that was not used for the hydrolysis were purged from the reaction chamber.

(Conditions)

For each of Examples and Comparative Examples, temperatures in the reaction of the above (2) and the hydrolysis of (3) and the numbers of cycles of (2) to (4) were each set as shown in Tables 1 and 2.

<Sol-gel method>

100 g of a diamond particle was cleaned at 60 °C/5 min. with "ACE CLEAN A-220" manufactured by Okuno Chemical Industries Co., Ltd. to perform a degreasing treatment, filtered, washed with water, cleaned with acetone, and then dried at 80 °C/1 h to perform a pretreatment. After that, a specified amount of a silica coating agent "Protector PW-S-B" (curing agent) manufactured by Okuno Chemical Industries Co., Ltd. was mixed, mixed and stirred therewith, and furthermore, a specified amount of "Protector PW-S-A" (main agent) manufactured by Okuno Chemical Industries Co., Ltd. was injected thereinto and stirred therewith at room temperature for six hours. The components were stirred, then, filtered, washed with water, cleaned with acetone and dried at 80 °C/1 h, thereby obtaining a diamond composite particle.

<CVD method>

A film was formed by the CVD method in a procedure described in the following (1) to (3).

(1) 50 g of a diamond particle manufactured by SAKIGAKE-Semiconductor Co., Ltd. was loaded into a plasma CVD container.
(2) TEOS (tetraethoxysilane) was supplied thereto as a reaction gas.
(3) A treatment was performed for two hours while irradiating the components with plasma with a high-frequency coil plasma generator, and a hydroxyl group on the surface of the particle and TEOS were reacted with each other, thereby obtaining a diamond composite particle.

(Analysis of average coating thickness)

(1) A cross section of the diamond composite particle or the diamond composite particle embedded in an epoxy resin was produced with a focused ion beam device (FIB).
(2) An elemental analysis was performed on the surface of the diamond composite particle while observing the cross section with an elemental analyzer attached to a scanning electron microscope (SEM-EDS), and an aluminum element was mapped, whereby a coating film that coated the diamond composite particle was visualized.
(3) For three diamond composite particles, three to four points were observed per particle, coating thicknesses at a total of 10 points were measured, and the average value thereof was regarded as the average coating thickness.
(4) The standard deviation of the coating thicknesses was calculated based on the coating thickness at each point and the average value thereof obtained in the above (3).

(Weight loss rate)

(1) A total of 3.3 parts by mass of the diamond composite particle and the dispersant were added to 1 part by mass of a resin, and a mixture thereof was stirred with a planetary stirrer under conditions of 1400 rpm and 1 min., thereby obtaining a resin composition having a loading rate of the diamond composite particle of 77% by mass.
(2) The composition obtained in the above (1) was used as a sample for weight loss rate measurement, and the sample was cured under conditions of 70°C and 60 min., thereby obtaining a cured product sample.
(3) The cured product sample was put into an oven heated to 150°C, and the sample weights were measured after 72 hours and after 168 hours from when the sample had been put into the oven.
(4) A value obtained by subtracting the sample weight after 168 hours from when the sample had been put into the oven from the sample weight after 72 hours from when the sample had been put into the oven from was regarded as the weight loss value, and the weight loss rate was calculated by the following formula.

Weight loss rate (%) = weight loss value/sample weight after 72 hours from when sample had been put into oven

(5) The weight loss rate calculated by the above-described method was evaluated by the following evaluation criteria.

A: Less than 0.2%
B: 0.2% or more and less than 0.5%
C: 0.5% or more and less than 1.0%
D: 1.0% or more

(Thermal conductivity)

(1) A resin composition was obtained by the same method as in the measurement of the weight loss rate.
(2) The composition obtained in the above (1) was used as a sample for thermal conductivity measurement, thermal conductivity was measured at 10 points in the sample using a thermal conductivity measuring instrument (product name: TCi, manufactured by C-Therm Technologies Ltd.), and the average value thereof was regarded as the thermal conductivity.
(3) The thermal conductivity measured by the above-described method was evaluated by the following evaluation criteria.

A: 1.20 W/(m·K) or more
B: 1.1 W/(m·K) or more and less than 1.20 W/(m·K)
C: 0.80 W/(m·K) or more and less than 1.1 W/(m·K)
D: Less than 0.80 W/(m·K)

[Components used]

Components used in each of Examples and Comparative Examples are as described below.

(Diamond particle)

Synthetic diamond (crushed product), manufactured by Tomei Diamond Co., Ltd.

(Resins)

Organopolysiloxane 1: Organopolysiloxane having vinyl groups at both ends of a molecular chain (vinyl group content: 0.17 mmol/g, viscosity: 410 mPa·s, weight-average molecular weight: 25400)
Organopolysiloxane 2 (component (A) and component (B)): A mixture of an organopolysiloxane having vinyl groups at both ends of a molecular chain (component (A)) and an organopolysiloxane having three or more hydrosilyl groups (component (B)) (vinyl group content: 0.15 mmol/g, hydrosilyl group content: 0.19 mmol/g, viscosity: 336 mPa·s, weight-average molecular weight: 25000, mass ratio (component (A): component (B)) = 90:10)

(Dispersant (coupling agent))

Silicone compound: Polyorganosiloxane (X) (hereinafter, also referred to as the wetter). A silicone compound having the following structure.

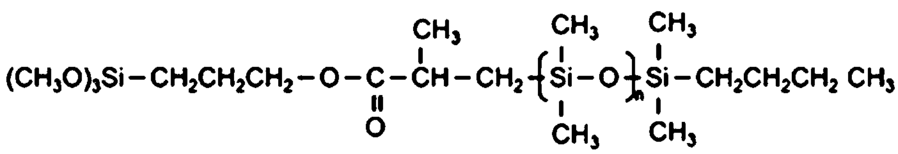

n = 10 to 15

[Example 1]

A diamond composite particle and a resin, which were to be blended together, were weighed with an electronic balance, then, injected into a sample vial in parts by mass shown in Table 1 and kneaded with "AWATORI RENTARO" manufactured by Thinky Corporation at 25°C and 1400 rpm for 30 seconds, thereby obtaining a resin composition. As the diamond composite particle, the diamond composite particle obtained by the above-described procedure of the ALD method was used.

[Examples 2 to 6 and Comparative Example 7]

The same operation as in Example 1 was performed except that the conditions of the ALD method were changed as shown in Tables 1 and 2.

[Comparative Example 1]

The same operation as in Example 1 was performed except that no coating films were formed on the surface of the diamond particle.

[Comparative Examples 2 to 4 and 6]

The same operation as in Example 1 was performed except that the method for forming the coating film, the material and the average coating thickness were changed as shown in Table 2.

[Comparative Example 5]

The same operation as in Example 1 was performed except that, instead of forming the coating film on the surface

of the diamond particle, "CMM-NP7 10-20" manufactured by Tomei Diamond Co., Ltd. (diamond composite particle having an average particle diameter of 10 μm and a 200 nm-thick nickel oxide coating film (Ni plating)) was used as the diamond composite particle.

[Table 1]

| | | | Example 1 | Example 2 | Example 3 | Example 4 | Example 5 | Example 6 |
|---|---|---|---|---|---|---|---|---|
| Production conditions | Conditions for ALD method | Temperature | 250°C | 250°C | 180°C | 180°C | 180°C | 180°C |
| | | Number of cycles | 10 | 5 | 30 | 20 | 10 | 5 |
| | Methods for forming coating film other than ALD method | | - | - | - | - | - | - |
| Coating film | Average coating thickness (nm) | | 1 | 0.5 | 3 | 2 | 1 | 0.5 |
| | Ratio (standard deviation/average coating thickness) | | 0.06 | 0.09 | 0.6 | 0.4 | 0.2 | 0.1 |
| | Material | | Alumina | Alumina | Alumina | Alumina | Alumina | Alumina |
| Diamond particle | Average particle diameter (μm) | | 10 | 10 | 10 | 10 | 10 | 10 |
| Composition | Resin (% by mass) | | 20 | 20 | 20 | 20 | 20 | 20 |
| | Coupling agent (% by mass) | | 3 | 3 | 3 | 3 | 3 | 3 |
| | Diamond composite particle (% by mass) | | 77 | 77 | 77 | 77 | 77 | 77 |
| Evaluation | Weight loss rate | | B | B | B | B | B | B |
| | Thermal conductivity | | A | A | B | B | A | A |

[Table 2]

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Production conditions | Conditions for ALD method | Temperature | - | - | - | - | - | - | 120°C |
| | | Number of cycles | - | - | - | - | - | - | 10 |
| | Methods for forming coating film other than ALD method | | - | Sol-gel method | Sol-gel method | CVD | Ni plating | CVD | ALD |
| Coating film | Average coating thickness (nm) | | 0 | 60 | 100 | 150 | 200 | 1 | 1 |
| | Ratio (standard deviation/average coating thickness) | | 0 | 0.2 | 0.2 | 1 | 0.2 | 1 | 0.8 |
| | Material | | None | Silica | Silica | Silica | Nickel oxide | Silica | Alumina |
| Diamond particle | Average particle diameter (μm) | | 10 | 10 | 10 | 10 | 10 | 10 | 10 |
| Composition | Resin (% by mass) | | 20 | 20 | 20 | 20 | 20 | 20 | 20 |
| | Coupling agent (% by mass) | | 3 | 3 | 3 | 3 | 3 | 3 | 3 |
| | Diamond composite particle (% by mass) | | 77 | 77 | 77 | 77 | 77 | 77 | 77 |
| Evaluation | Weight loss rate | | D | B | B | B | C | D | C |
| | Thermal conductivity | | B | D | D | D | D | B | B |

* The content of the resin is the total content of a mixture of the organopolysiloxane 1 and the organopolysiloxane 2 in a mass ratio of 1:1.
* The average particle diameters of the diamond particles in Tables 1 and 2 are measurement values after coating.

As clear from Examples described above, in the diamond composite particle that was contained in the resin composition produced in each of Examples, the average coating thickness and the ratio of the standard deviation of the coating thickness to the average coating thickness were both within predetermined ranges, and it was thus possible to impart excellent heat resistance and thermal conductivity to the resin composition.

On the other hand, the resin composition produced in Comparative Example 1 contained only a diamond particle having a non-coated surface as the diamond particle, and it was thus not possible to impart excellent heat resistance to the resin composition.

In addition, the resin compositions produced in Comparative Examples 2 to 5 contained a diamond composite particle having an average coating thickness that was larger than a predetermined value, and it was thus not possible to impart excellent thermal conductivity to the resin composition.

Furthermore, the resin compositions produced in Comparative Examples 6 and 7 contained a diamond composite particle having a ratio of the standard deviation of the coating thickness to the average coating thickness that was larger than a predetermined value, and it was thus not possible to impart excellent heat resistance to the resin composition.

## Claims

1. A diamond composite particle comprising:

   a diamond particle; and
   a coating film that coats a surface of the diamond particle, the coating film comprising a metal oxide,
   the coating film having an average coating thickness of 0.5 nm or more and 3 nm or less, and a ratio of a standard deviation of a coating thickness to the average coating thickness (standard deviation/average coating thickness) being 0.6 or less.

2. The diamond composite particle according to claim 1, wherein the metal oxide is aluminum oxide.

3. The diamond composite particle according to claim 1, wherein the diamond composite particle has an average particle diameter of 1 μm or more and 80 μm or less.

4. A resin composition comprising:

   a base resin; and
   the diamond composite particles according to any one of claims 1 to 3.

5. The resin composition according to claim 4, wherein the base resin comprises at least one selected from a silicone resin, an epoxy resin, a polyolefin resin and an acrylic resin.

6. The resin composition according to claim 4, further comprising

   a dispersant, wherein
   the dispersant has a different structure from the base resin.

7. The resin composition according to claim 4, wherein a content of the diamond composite particles in the resin composition is 10% by mass or more and 99% by mass or less based on 100% by mass of the resin composition.

Fig. 1

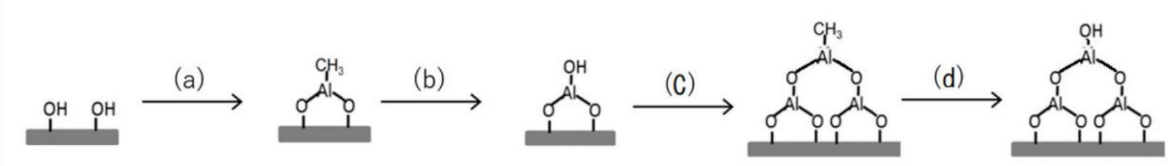

## INTERNATIONAL SEARCH REPORT

International application No.
**PCT/JP2024/013729**

### A. CLASSIFICATION OF SUBJECT MATTER

***C23C 16/40***(2006.01)i; ***C01B 32/25***(2017.01)i; ***C08K 3/013***(2018.01)i; ***C08L 101/00***(2006.01)i; ***C23C 16/44***(2006.01)i; ***H01L 23/373***(2006.01)i
FI: C23C16/40; C23C16/44 Z; C01B32/25; C08L101/00; H01L23/36 M; C08K3/013

According to International Patent Classification (IPC) or to both national classification and IPC

### B. FIELDS SEARCHED

Minimum documentation searched (classification system followed by classification symbols)

C23C16/40; C01B32/25; C08K3/013; C08L101/00; C23C16/44; H01L23/373

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | US 2008/0073127 A1 (SMITH INTERNATIONAL, INC.) 27 March 2008 (2008-03-27) paragraphs [0042]-[0056] | 1-3 |
| A | | 4-7 |
| X | US 2019/0136374 A1 (NATIONAL OILWELL DHT, L.P.) 09 May 2019 (2019-05-09) paragraphs [0036]-[0039], fig. 4-5 | 1, 3 |
| A | | 2, 4-7 |
| X | JP 7-053205 A (AGENCY OF IND. SCIENCE & TECHNOL.) 28 February 1995 (1995-02-28) paragraphs [0021]-[0028] | 1-3 |
| A | | 4-7 |
| A | CN 115011947 A (XIAMEN YUNMAO TECHNOLOGY CO., LTD.) 06 September 2022 (2022-09-06) entire text | 1-7 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 June 2024** | **25 June 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
PCT/JP2024/013729

C. DOCUMENTS CONSIDERED TO BE RELEVANT

| Category* | Citation of document, with indication, where appropriate, of the relevant passages | Relevant to claim No. |
|---|---|---|
| A | JP 2018-111814 A (SEKISUI CHEM. CO., LTD.) 19 July 2018 (2018-07-19) entire text | 1-7 |
| A | JP 2018-111883 A (ALLIED MATERIAL CORP.) 19 July 2018 (2018-07-19) entire text | 1-7 |
| A | JP 2014-084331 A (SHOWA DENKO K.K.) 12 May 2014 (2014-05-12) entire text | 1-7 |
| A | WO 2022/085134 A1 (FUJI DIE CO., LTD.) 28 April 2022 (2022-04-28) entire text | 1-7 |

Form PCT/ISA/210 (second sheet) (July 2022)

**INTERNATIONAL SEARCH REPORT**
**Information on patent family members**

International application No.
**PCT/JP2024/013729**

| Patent document cited in search report | Publication date (day/month/year) | Patent family member(s) | Publication date (day/month/year) |
|---|---|---|---|
| US 2008/0073127 A1 | 27 March 2008 | (Family: none) | |
| US 2019/0136374 A1 | 09 May 2019 | WO 2016/183435 A1<br>EP 3294925 A1<br>EP 3505654 A1 | |
| JP 7-053205 A | 28 February 1995 | US 5536485 A<br>specification, column 23, line 37 to column 25, line 45 | |
| CN 115011947 A | 06 September 2022 | (Family: none) | |
| JP 2018-111814 A | 19 July 2018 | (Family: none) | |
| JP 2018-111883 A | 19 July 2018 | US 2017/0145280 A1<br>entire text<br>WO 2016/035795 A1<br>EP 3190198 A1<br>CN 106795596 A<br>CN 110656259 A<br>CN 114032413 A | |
| JP 2014-084331 A | 12 May 2014 | (Family: none) | |
| WO 2022/085134 A1 | 28 April 2022 | JP 6849267 B1 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013506029 W
- JP 2005501176 W